**Europäisches Patentamt**

**European Patent Office**

**Office européen des brevets**

(19)

(11) **EP 1 445 585 A1**

(12) **EUROPÄISCHE PATENTANMELDUNG**

(43) Veröffentlichungstag:
**11.08.2004 Patentblatt 2004/33**

(51) Int Cl.⁷: **G01D 5/38**

(21) Anmeldenummer: **03022310.1**

(22) Anmeldetag: **02.10.2003**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(30) Priorität: **02.10.2002 DE 10246268**

(71) Anmelder: **PWB-Ruhlatec Industrieprodukte
GmbH
99846 Seebach (DE)**

(72) Erfinder:
• **Braun, Paul-Wilhelm
53842 Troisdorf (DE)**
• **Tenca, Vittorio
37013 Caprino Veronese (VR) (IT)**
• **Carradori, Corrado
37026 Pescantina (VR) (IT)**

(74) Vertreter: **Müller-Wolff, Thomas, Dipl.-Ing.
Patentanwalt,
Postfach 19 02 17
53037 Bonn (DE)**

(54) **Encoderanordnung**

(57)    Es wird eine Encoderanordnung beschrieben, bestehend aus einem Motor (10) mit einer Motorwelle (11), auf der eine Taktscheibe (12) befestigt ist, einer Signalquelle zur Erzeugung eines optischen Signals sowie einer Strahlenmaske (18) zur Formung des optischen Signals. Diese ist dadurch gekennzeichnet, dass die Strahlenmaske mit Codebalken aus pit- und land-Strukturen versehen ist, die eine Beugungs- und Interferenzstruktur aufweisen.

Fig. 3

EP 1 445 585 A1

**Beschreibung**

Die Erfindung betrifft eine Encoderanordnung bestehend aus einem Motor mit einer Motorwelle, auf der eine Taktscheibe befestigt ist, einer Signalquelle eines optischen Signals sowie einer Strahlenmaske zur Formung des optischen Signals.

Encoderanordnungen der eingangs genannten Art dienen zur Messung von Bewegungsvorgängen aller Art, wobei die Messsignale zur Steuerungs- oder Positionsbestimmung von Maschinenteilen eingesetzt werden können. Dabei werden hohe Anforderungen an die Messgenauigkeit bei schnellen Bewegungsabläufen gestellt. Außerdem muß dafür gesorgt werden, dass die optischen Signale absolut parallel verlaufen, und sich bei einer Änderung der Drehrichtung keine Messfehler ergeben.

Encoder werden in hohen Stückzahlen als Massenprodukte hergestellt. Die Kosten werden maßgeblich durch die Fertigung und hier wiederum durch den Aufwand für die Justierung der Bauteile bestimmt.

Aufgabe der vorliegenden Erfindung ist es eine Encoderanordnung der eingangs genannten Art derart weiterzubilden, dass die Messgenauigkeit bei gleichzeitiger Reduzierung der Fertigungskosten gesteigert wird.

Diese Aufgabe wird erfindungsgemäß durch folgende Maßnahmen gelöst:

1. Die Codebalken der Strahlenmaske sind mit pit- und land- strukturen versehen, die eine Beugungs- und Interferenzstruktur aufweisen.

2. Vorzugsweise besteht die Beugungsstruktur aus einer 2D-Submikrometer-Gitterstruktur.

3. Um die Fertigungskosten zu senken, ist die Strahlenmaske mit einer Maskenhalterung integriert.

4. Zur Erhöhung der Positionierungsgenauigkeit weist die Maskenhalterung eine Aussparung für die Motorwelle und einen Maskenbereich mit Mikro-Interferenzstrukturen und makroskopischen Strukturen auf.

5. Das Verschleißverhalten der Strahlenmaske kann durch die Verwendung von Polycarbonat verbessert wrden, wobei die Bereiche zwischen den Codebalken transparent ausgebildet sind und die pit- und land-Strukturen einen Dickenunterschied D aufweisen, der folgender Funktion genügt:

$$D = L / 2 (n - 1)$$

Mit n = 1,5 und L = Wellenlänge des optischen Signals.

6. Wenn in den Strahlengang ein prismatischer Körper zur Strahlumlenkung und Strahlformung eingebracht ist, können die Signalquellen und der Signalempfänger auf einer Seite der Taktscheibe angeordnet sein.

7. Besonders gute Parallelität der optischen Signale lässt sich dadurch erreichen, dass der prismatische Körper eine im wesentlichen dachförmige Grundstruktur aufweist, wobei der eintretende und der austretende Strahl an den Dachninnenflächen refektiert wird.

8. Um möglichst einfach aufgebaute Signalquellen zu verwenden ist es erforderlich, eine Kondensoroptik im Bereich des eintretenden Lichtstrahls in die Grundfläche des prismatischen Körpers zu integrieren. Im Bereich des austretenden Lichtstrahls kann die Beugung- und Interferenzstruktur in den prismatischen Körper eingeformt sein, sodaß sich keine Justierprobleme ergeben.

9. Zur Steigerung des Integrationsgrades und zur Verringerung der Fertigungskosten wird in den prismatischen Körper eine Maske mit Maskenhalterung und die Signalquelle integriert. Hierzu ist im Bereich des Strahleneintritts eine Verbindungsebene mit Formschluss zwischen einer Leiterplatte, die zur Energieversorgung dient, und dem Prisma ausgebildet.

10. Die Leiterplatte hat mindestens eine Anschlussebene, auf der der prismatische Körper mit der Signalquelle und der Strahlungsempfänger mittels einfacher Steckverbindungen angeordnet werden können.

11. In einer bevorzugten Ausführungsform wird die Maskenhalterung als Präzisions-Spritzteil ausgebildet mit einer gemeinsamen Integrationsebene für die Strahlenquelle, den prismatischen Körper und den Strahlenempfänger.

Im folgenden wird die Erfindung anhand mehrer Beispiele erläutert:

Es zeigen:

Figur 1: Maskenhalterung mit einer Strahlenmaske aus pit- und land-Strukturen

Figur 2: Prinzipeller Aufbau eines prismatischen Körpers zur Strahlumlenkung und Strahlumformung

Figur 3: Gesamtansicht eines Encodersystems in Explosiv - Darstellung

Figur 4: prismatischer Körper mit Integrations- und Verbindungsebene

Bekanntlich bestehen die Codierungen der Taktscheiben von Encoderanordnungen aus einer Folge von Streifen oder Balken. Üblicherweise wechseln sich Streifen hoher Transmission mit solchen niedriger Transmission bzw. Reflektion ab, sodaß die von einem Sender ausgehenden Signale mit den sich dabei verändernden optischen Strukturen / bzw. Eigenschaften in dem Geberelement modifiziert werden. In einer Signalverarbeitungsstufe werden aus den modifizierten Signalen Informationen für die Positions- oder Längenbestimmung gewonnen.

In einer bevorzugten Ausführungsform der vorliegenden Erfindung wird die Maßverkörperung auf einer lichtbeugenden 2D- Submikrometer-Gitterstruktur aufgebaut. In der dritten Dimension wird die Phase der transmittierten oder reflektierten Lichtwelle bestimmt. Durch Interferenz mehrer Teilwellen lassen sich die in ihrer Phasenlage veränderten Lichtwellen entweder verstärken oder abschwächen. Das hieraus resultierende Signal kann innerhalb einer Signalverarbeitungseinrichtung als Steuersignal zur Positions- und Wegbestimmung benutzt werden.

Die Herstellung der erfindungsgemäßen Taktscheibe erfolgt beispielweise nach der herkömmlichen Filmtechnologie mit Absorber-Pattern und die Maske wird nach der Technologie der transmissiven Interferenz-Beugungsanordnung realisiert. Durch die Kombination dieser Technologien wird es ermöglicht, unterschiedliche Integrationen von Funktionselementen bei der Sensor-Masken-Anwendung durchzuführen.

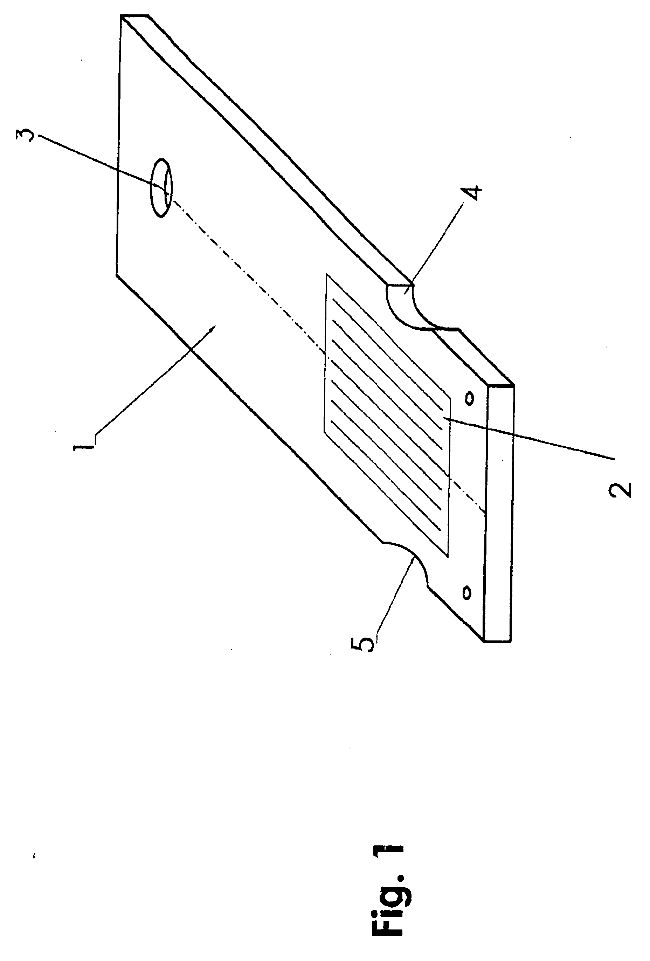

So ist in der Figur 1 ein Maskenbereich mit Micro- und Macrostruktur auf einer Oberfläche der Maskenhalterung angeordnet. Die Maskenhalterung 1 ist unterteilt in einen Maskenbereich 2 und einen Justierbereich 3.Dieser besteht beispielsweise aus einer Bohrung 3 für eine Motorwelle des Encoders (nicht dargestellt). Die Ausformungen 4, 5 bilden weitere Positionierungsmöglichkeiten für die Maskenhalterung.

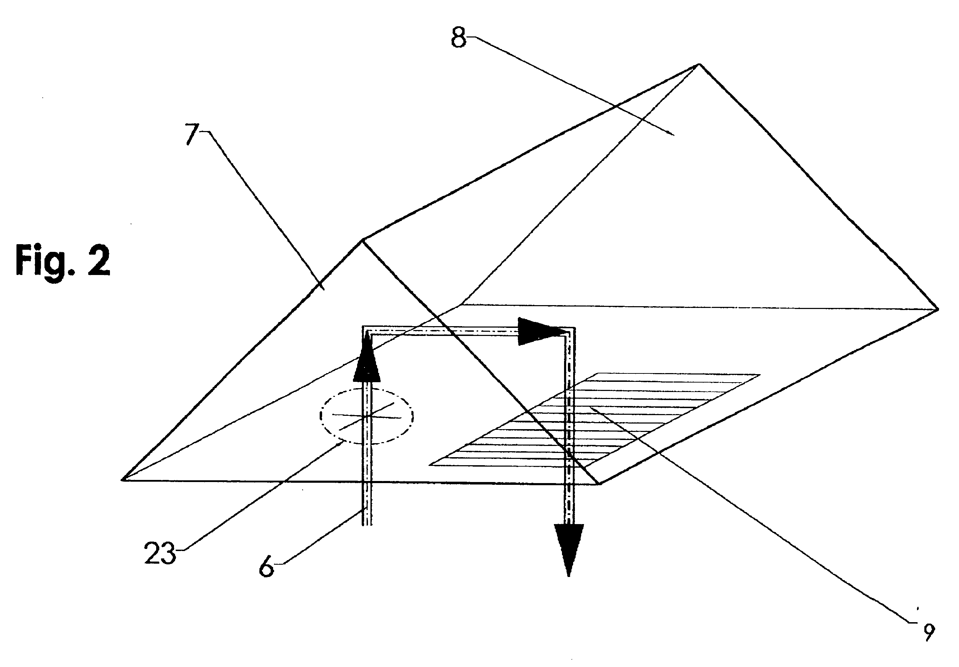

In Figur 2 ist der Strahlengang in einem prismatischen Körper dargestellt. Im Bereich der Eintrittseite des Strahles kann eine Kondensoroptik 6 angeordnet werden, die zur Verbesserung der Parallelität oder zur Strahlenbündelung dient. Da der prismatische Körper eine dachförmige Grundstruktur aufweist, wird der eintretende und der austretende Strahl an den Dachinnenflächen 7,8 reflektiert, so dass er parallel zur Eintrittsrichtung den prismatischen Körper im Bereich der Strahlenmaske 9 verläßt.

Bei der konstruktiven Gestaltung der Strahlenmaske geht man von den pit- und land-Strukturen sowie deren Dickenunterschied D aus, dessen Betrag nach der im Patentanspruch 5 angegebenen Formel berechnet wird. Das Material des Geberelementes kann beispielsweise auch als Polycarbonat mit einer Brechzahl n = 1,5 bestehen, so dass das Verschleißverhalten gegenüber herkömmlichen Materalen erheblich verbessert wird. Vergleichsuntersuchungen haben gezeigt, dass die Lebensdauer von Masken mit dem erfindungsgemäßen Material um den Faktor 5 gegenüber herkömmlichen Vorrichtungen erhöht wird.

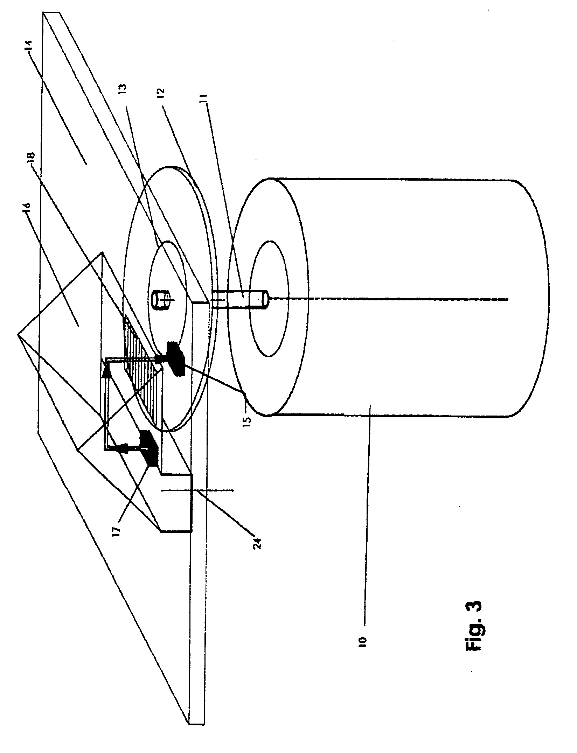

Der in Figur 3 dargestellt Gesamtaufbau der erfindungsgemäßen Encoderanordnung besteht aus folgenden Elementen:

- Motor 10 mit Motorwelle 11
- Taktscheibe 12 mit Nabe 13
- Leiterplatte 14 mit Signalempfänger 15
- Prismakörper 16 mit Signalquelle 17 und Strahlenmaske 18

Aus der Darstellung ist folgendes erkennbar:

Alle Bauteile der erfindungsgemäßen Encoderanordnungen sind vollständig integriert, wodurch ihre gegenseitige Positionierung durch einfache Steckverbindungen erfolgen kann. Dadurch sinken die Fertigungskosten und es erhöht sich die Fertigungsgenauigkeit um den Faktor 10.

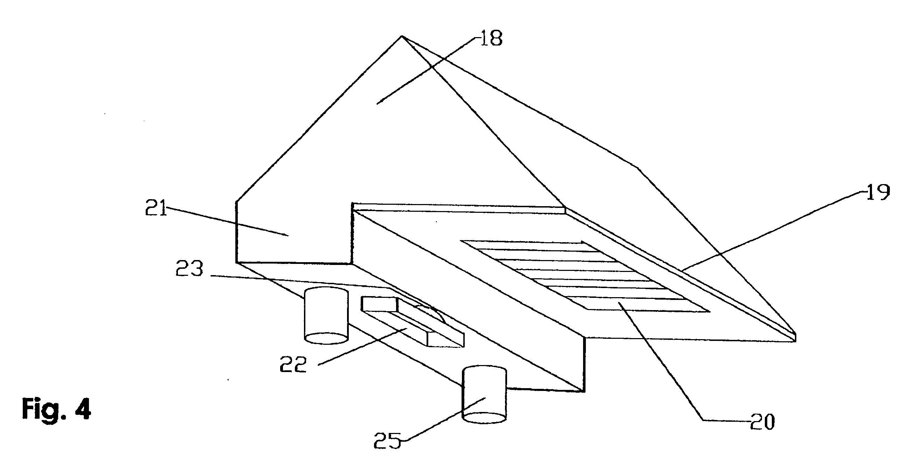

Anhand von Figur 4 kann die Vollintegration von Maske, Prisma, Signalquelle und Signalformung noch einmal verdeutlicht werden. Der prismatische Körper 18 ist mit einer Maskenhalterungen 19 ausgestattet, in die die Maske 20 integriert ist.

In einem abstandsgebenden Formteil 21, der sich über einen Teil der Grundfläche des prismatischen Körpers 18 erstreckt, ist eine Ausnehmung für die Signalquelle eingeformt. Weitere Ausnehmungen können in den Strahlengang eingebracht werden, beispielsweise für eine Kondensoroptik 23.

Zur Positionierung des prismatischen Körpers 18 auf der Leiterplatte werden vorzugsweise Befestigungszapfen 24,25 verwendet. Hiermit lässt sich mit Hilfe einer einfachen Steckverbindung eine schnelle und exakte Positionierung des optischen Signalgebers bzw. der Geberelemente wie die Taktscheibe und Taktlineale erreichen.

**Patentansprüche**

1. Encoderanordnung , bestehend aus einem Motor mit einer Motorwelle , auf der eine Taktscheibe befestigt ist , einer Signalquelle zur Erzeugung eines optischen Signals sowie einer Strahlenmaske zur Formung des optischen Signals,
dadurch- gekennzeichnet, dass
die- Strahlenmaske mit Codebalken aus pit- und land-Strukturen versehen ist, die eine Beugungs - und Interferenzstruktur aufweisen.

2. Encoderanordnung nach Anspruch 1 ,
**dadurch gekennzeichnet, dass**

die Beugungsstruktur aus einer 2D-Submikrometer-Gitterstruktur dargestellt wird.

3. Encoderanordnung nach Anspruch 1 oder 2 ,
**dadurch gekennzeichnet , dass**
in die Strahlenmaske eine Maskenhalterung integriert ist.

4. Encoderanordnung nach Anspruch 3 ,
**dadurch gekennzeichnet , dass**
die Maskenhalcerung eine Aussparung für die Motorwelle und einen Maskenbereich mit Mikro- Interferenzstrukturen und makroskopischen Strukturen aufweist.

5. Encoderanordnung nach einem der Ansprüche 1-4,
**dadurch gekennzeichnet, dass**
die Strahlenmaske aus einem Polycarbonat besteht, wobei die Bereiche zwischen den Codebalken transparent ausgebildet sind und die pit- und land-Strukturen einen Dickenunterschied D aufweisen, der folgender Funktion genügt :

$$D = L / 2 (n - 1)$$

mit $n = 1.5$ und L = Wellenlänge des optischen Signals.

6. Encoderanordnung nach einem der Ansprüche 1 - 5 ,
**dadurch gekennzeichnet, dass**
in den Strahlengang ein prismatischer Körper zur Strahlumlenkung und Strahlformung eingebracht ist.

7. Encoderanordnung nach Anspruch 6 ,
**dadurch gekennzeichnet, dass**
der prismatische Körper eine im wesentlichen dachförmige Grundstruktur aufweist, wobei der eintretende und der austretende Strahl an den Dachinnenflächen reflektiert werden.

8. Encoderanordnung nach Anspruch 7 ,
**dadurch gekennzeichnet, dass**
in der Grundfläche des prismatischen Körpers im Bereich des eintretenden Lichtstrahls eine Kondensoroptik und im Bereich des austretenden Lichtstrahls die Beugungs - und Interferenzstruktur ausgebildet ist.

9. Encoderanordnung nach einem der Ansprüche 6 - 8 ,
**dadurch gekennzeichnet, dass**
in den prismatischen Körper die Maskenhalterung und die Signalquelle integriert ist, wobei im Bereich des Strahleneintritts eine Verbindungsebene mit einem Formschluß zwischen einer Leiterplatte und dem Prisma ausgebildet ist.

10. Encoderanordnung nach Anspruch 9,
**dadurch gekennzeichnet, dass**
die Leiterplatte mit einer Anschlussebene versehen ist und dass auf der einen Anschlussebene der prismatische Körper mit der Signalquelle und der Strahlenempfänger angeordnet ist.

11. Encoderanordnung nach Anspruch 10 ,
**dadurch gekennzeichnet, dass**
die Maskenhalterung als Präzisions-Spritzgußteil ausgebildet ist mit einer gemeinsamen Integrationsebene für die Strahlenquelle, den prismatischen Körper und den Strahlenempfänger.

Fig. 1

Fig. 2

Fig. 3

EP 1 445 585 A1

Fig. 4

**Europäisches Patentamt**

## EUROPÄISCHER RECHERCHENBERICHT

Nummer der Anmeldung

EP 03 02 2310

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 917 182 A (ISHIZUKA KOU) 29. Juni 1999 (1999-06-29) * Spalte 4, Zeile 23 - Spalte 5, Zeile 5 * --- | 1 | G01D5/38 |
| A | DE 195 18 714 A (BAUMER ELECTRIC AG) 21. Dezember 1995 (1995-12-21) * das ganze Dokument * --- | 1-11 | |
| A | US 5 602 388 A (MAENZA GLENN J) 11. Februar 1997 (1997-02-11) * Spalte 4, Zeile 3 - Zeile 10 * --- | 1 | |
| A | DE 196 37 625 A (BOSCH GMBH ROBERT) 26. März 1998 (1998-03-26) * Zusammenfassung * ----- | 1 | |

| | | | RECHERCHIERTE SACHGEBIETE (Int.Cl.7) |
|---|---|---|---|
| | | | G01D |

Der vorliegende Recherchenbericht wurde für alle Patentansprüche erstellt

| Recherchenort | Abschlußdatum der Recherche | Prüfer |
|---|---|---|
| MÜNCHEN | 28. April 2004 | Messelken, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**  EP 03 02 2310

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-04-2004

| Im Recherchenbericht angeführtes Patentdokument | | Datum der Veröffentlichung | Mitglied(er) der Patentfamilie | | Datum der Veröffentlichung |
|---|---|---|---|---|---|
| US 5917182 | A | 29-06-1999 | JP | 8210824 A | 20-08-1996 |
| DE 19518714 | A | 21-12-1995 | CH | 690862 A5 | 15-02-2001 |
| | | | DE | 19518714 A1 | 21-12-1995 |
| | | | IT | MI951084 A1 | 18-12-1995 |
| | | | JP | 8043135 A | 16-02-1996 |
| US 5602388 | A | 11-02-1997 | JP | 8111060 A | 30-04-1996 |
| | | | SG | 34263 A1 | 06-12-1996 |
| DE 19637625 | A | 26-03-1998 | DE | 19637625 A1 | 26-03-1998 |

EPO FORM P0461

Für nähere Einzelheiten zu diesem Anhang : siehe Amtsblatt des Europäischen Patentamts, Nr.12/82